# EUROPEAN PATENT APPLICATION

(11) **EP 0 718 642 A1**
(43) Date of publication of application: **26.06.1996**
(21) Application number: 95309197.2
(22) Date of filing: 18.12.1995
(51) Int. Cl.: G02B 1/02, G02B 5/18, C23C 16/26, C30B 29/04

(54) **Diffractive optics**

(30) Priority: 20.12.1994 GB 9425712
(71) Applicant: DE BEERS INDUSTRIAL DIAMOND DIVISION (PROPRIETARY) LIMITED, Johannesburg, Transvaal (ZA)
(72) Inventor: Sussmann, Ricardo S., Guildford, Surrey (GB); Stewart, Andrew D. G., Reading, Berks (GB); Wort, Christopher J. H., Wantage, Oxon (GB); Cooper, Martin, Marlow, Bucks (GB)
(74) Representative: Nicholls, Michael John

(57) **Abstract**

The invention provides a diffractive optical element which is made of CVD diamond. The element comprises a CVD diamond body (24) having one or more light-diffracting features on or in a first surface (26) and a second surface (28) spaced from the first surface (26).

## Description

### BACKGROUND OF THE INVENTION

This invention relates to diffractive optics.

Diffractive optics encompass optical components or elements such as: zone plates, diffraction gratings, anti-reflection structures, polarisation beam splitters, wavelength division devices, fan-out devices and coherent laser addition and optical processor components. Diffractive optical elements make use of light diffraction, as opposed to refraction, and rely in most cases on the engraving, machining or imprinting, by any one of a number of different techniques, of an array of features on a surface of a material.

Diamond is the hardest substance known to man and may be found in nature or produced synthetically. One method of producing diamond synthetically is by chemical vapour deposition (CVD). Diamond produced by CVD is known as CVD diamond. CVD diamond may be produced by providing a gaseous carbon compound such as a hydrocarbon, subjecting the gaseous carbon compound to energy such as microwave energy to dissociate the compound into carbon-containing ions, atoms or radicals, in the presence of an activating gas such as oxygen, and allowing the carbon-containing ions, atoms or radicals to deposit on a suitable substrate and form a diamond layer. Such methods are well documented in the literature, including the patent literature.

With the use of CVD, it is possible to manufacture large area flat plates and three-dimensional shapes of polycrystalline diamond with optical properties close to the highest purity available type IIa natural diamond.

### SUMMARY OF THE INVENTION

According to the present invention, a diffractive optical element comprises a CVD diamond body having one or more light-diffracting features on or in a first surface and a second surface spaced from the first surface.

### BRIEF DESCRIPTION OF THE DRAWINGS

Figure 1 is a sectional side view of a substrate having a CVD diamond layer deposited thereon, and
Figure 2 is a sectional side view of the CVD diamond layer removed from the substrate.

### DESCRIPTION OF EMBODIMENTS

The diffractive optical element of the invention has a first surface having one or more light-diffracting features and a second surface spaced from the first surface. In use, the element will be so positioned as to allow light to pass through the two surfaces and, in particular, to be diffracted by the light-diffracting features. The manner in which the element is used will vary according to the particular use to which it is to be put and is known in the art.

The second surface may be flat or curved or it may also have one or more light-diffracting features on or in it.

The surface or surfaces having one or more light-diffracting features are preferably suitably profiled to provide these features.

One or both of the surfaces of the diffractive optical element may be polished. The CVD diamond is preferably a translucent diamond of high purity and having the optical and thermal properties of, or substantially of, type IIa natural diamond.

The diffractive optical element of the invention is structurally the same as known element. It is characterised by being made of a CVD diamond. The use of CVD diamond as the material for the diffractive optical element gives rise to a number of advantages as indicated hereinafter:
1. Considerably less bulk of material is required when compared with a refractive optical element.
2. There is a need only to imprint discrete features, usually relatively small, rather than shaping the entire surface in a spherical or similar shape. Because of the extreme hardness of diamond it is intrinsically difficult to shape diamond elements or parts.
3. CVD diamond allows for the manufacture of robust, abrasion and chemical resistance optical elements with a high refractive index.
4. Thermal effects are minimised. Diamond offers advantages in this respect due to its high thermal conductivity, low coefficient of thermal expansion and high resistance to thermal shock.
5. Large area diamond optical elements are possible.

Various methods of manufacturing a diffractive optical element of the invention are possible. These methods include:

### 1. Growth on a pre-shaped substrate

It is known that CVD diamond can grow conformally onto a pre-shaped surface. The substrate may be silicon, silicon carbide, a metal such as W or Mo or the like. These substrates may be pre-shaped using either photolithography, diamond single-point electroforming machining or any other suitable technique. A CVD diamond layer is then grown on the shaped or profiled surface of the substrate and the substrate removed after growth by etching or by controlled delamination. The profiled surface of the CVD diamond layer, after removing the substrate, should require no further polishing or processing. Only the growth surface, i.e. the surface opposite to the profiled surface, may need to be polished using diamond polishing techniques known in the art.

### 2. Etching

A suitable mask can be patterned on a surface of a CVD diamond layer or body using conventional semiconductor photolithographic techniques (or e-beam lithography). The patterned diamond surface can then be etched using, for instance, oxygen or hydrogen plasma etching. The mask material must be able to tolerate the aggressive effects of the plasma etching.

### 3. Imprinting

It is known that some carbide forming metals, if pressed on a diamond surface at elevated temperatures, will dissolve carbon resulting in the physical removal of material from the surface. This effect has been successfully used to cut and shape CVD diamond with, for example, hot wires. In order to shape a diffractive optical component a metal surface may be shaped by machining or photolithography to the desired shape and pressed under elevated temperatures to a CVD diamond surface for the required amount of time. A variant of this technique is to have a metal pattern of a suitable carbide forming metal imprinted on the surface by, for instance, thermal evaporation or sputtering. The surface can then be heated to a suitable temperature so that the metal dissolves carbon to a predetermined depth. After cleaning, this technique will leave a suitable shaped diffractive optical element.

### 4. Laser Ablation

Lasers such as the UV excimer lasers are known to ablate CVD diamond surfaces with the possibility of achieving submicron spatial resolution. This technique can be used to engrave the desired diffractive optic features on to the diamond surface.

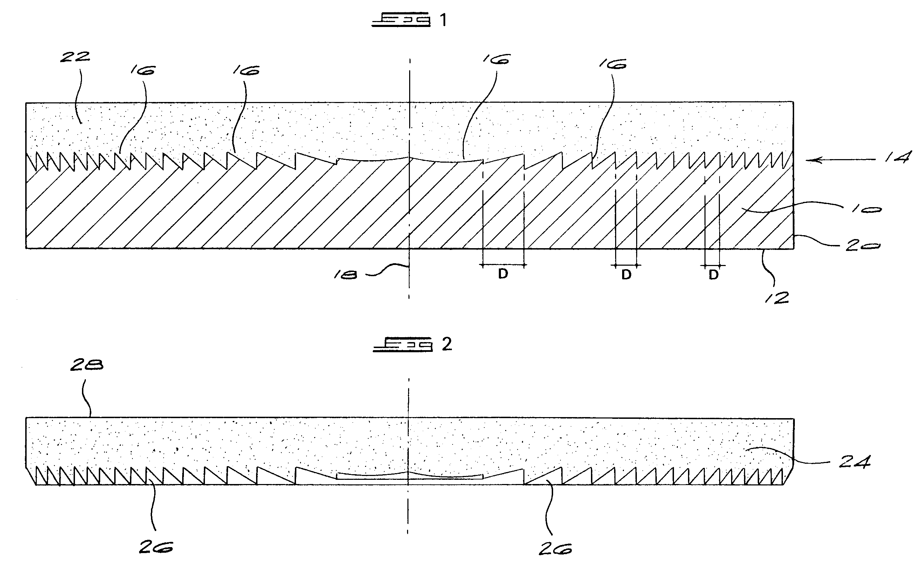

An example of the invention will now be described with reference to Figures 1 and 2 of the accompanying drawings.

Figure 1 is a sectional side view of a substrate having a CVD diamond layer deposited thereon. Referring to this drawing, a substrate 10, typically made of silicon, has a lower surface 12 and an upper profiled surface 14. The upper profiled surface has typically been diamond point machined to the desired pattern and profile. The substrate 10 is disc-shaped and the upper profiled surface 14 consists of a series of concentric steps 16. The depth D of each step 16 decreases from the centre 18 of the substrate to the periphery 20. Such a profile provides an effective light-diffracting profile for a lens. A layer 22 of diamond is thereafter deposited on the profiled surface 14 using any known CVD method. By way of example, methane gas may be the hydrocarbon gas which is dissociated by means of microwave energy in the presence of hydrogen gas. The temperature of the substrate will typically be maintained at a temperature in the range of about 800°C to 1000°C.

A CVD diamond diffractive optical element 24 is produced by removing the substrate 10 from the layer 22, typically using a strong inorganic acid or mixtures of acids. A sectional side view of such an element is shown by Figure 2. The surface 26 of the element 22 replicates the profiled surface 14 of the substrate 10. This replicated surface 26 does not require polishing. The opposite surface 28 of the element should be polished and may have a flat or curved profile. The resulting diffractive optical element is a lens which may be used in any known manner.

The diffractive optical element of the invention may, depending on the nature of the profiled surface, be used as a master for pressing a component such as a compact disc, grating or hologram.

## Claims

1. A diffractive optical element comprises a CVD diamond body (24) having one or more light-diffracting features on or in a first surface (26) and a second surface (28) spaced from the first surface (26).

2. A diffractive optical element according to claim 1 wherein the second surface (28) is flat or curved.

3. A diffractive optical element according to claim 1 wherein the second surface (28) has one or more light-diffracting features on or in it.

4. A diffractive optical element according to any one of the preceding claims wherein the surface or surfaces (26) having one or more light-diffracting features are suitably profiled to provide these features.

5. A diffractive optical element according to any one of the preceding claims wherein either or both of the first and second surfaces (26, 28) are polished.

6. A diffractive optical element according to any one of the preceding claims wherein the CVD diamond is a translucent diamond of high purity having the optical and thermal properties of, or substantially of, type IIa natural diamond.

7. Use of CVD diamond in the manufacture of a diffractive optical element.
